# EUROPEAN PATENT APPLICATION

(11) **EP 4 738 430 A1**
(43) Date of publication of application: **06.05.2026**
(21) Application number: 23943779.1
(22) Date of filing: 19.10.2023
(51) Int. Cl.: H01L 21/67

(54) **SUBSTRATE PROCESSING DEVICE, MAPPING DEVICE, SUBSTRATE PROCESSING METHOD, SEMICONDUCTOR DEVICE MANUFACTURING METHOD, AND PROGRAM**

(30) Priority: 30.06.2023 JP 2023107929
(71) Applicant: Kokusai Electric Corporation, Tokyo 101-0045 (JP)
(72) Inventor: HAYASHI, Akinari, Toyama-shi, Toyama 939-2393 (JP); TEZUKA, Shigenori, Toyama-shi, Toyama 939-2393 (JP); KUROSAWA, Toshiharu, Toyama-shi, Toyama 939-2393 (JP); SHIBATA, Jin, Toyama-shi, Toyama 939-2393 (JP)
(74) Representative: Verscht, Thomas Kurt Albert
(86) International application number: PCT/JP2023/037795
(87) International publication number: WO 2025/004393

(57) **Abstract**

Provided is a technology capable of economically and safely operating a substrate processing device by mixing wafers different in material. The substrate processing device comprises: a mapping device that determines a material of a substrate transported into the substrate processing device while the substrate is stored in a carrier; and a control unit configured to hold first information relating to the material of the transported substrate in the substrate processing device while updating the first information and to be able to control the substrate processing device so as to send out, when the first information does not satisfy a condition determined for a current operation mode among conditions each determined for each of the plurality of operation modes, the carrier storing the substrate that does not satisfy the predetermined condition.

## Description

### [Technical Field]

The present disclosure relates to a substrate processing apparatus, a mapping apparatus, a substrate processing method, a method of manufacturing a semiconductor device and a program.

### [Related Art]

At a cassette transfer table on which a wafer cassette transferred by an external transfer apparatus or a person is placed, a loading (storage) state of a wafer in the wafer cassette may be checked (that is, a wafer mapping may be checked) (for example, Patent Document 1).

### [Related Art Document]

### [Patent document]

Patent Document 1: Japanese Patent Application Laid-Open No. H10-150094.
Patent Document 2: International Patent Publication No. WO2018/154829.
Patent Document 3: Japanese Patent Application Laid-Open No. 2012-182351.
Patent Document 4: Japanese Patent Application Laid-Open No. 2015-106575.
Patent Document 5: Japanese Patent Application Laid-Open No. 2011-171648.

### [Disclosure]

### [Technical Problem]

In a batch type substrate processing apparatus, wafers made of different materials, such as Si (silicon) and SiC (silicon carbide), may be loaded together into a process furnace to perform a heat treatment process. However, some wafer may be made of such material that cannot be used at a process temperature. Therefore, it is preferable to provide a protection function capable of stopping such a process when such a wafer is erroneously handed over to the batch type substrate processing apparatus.

According to the present disclosure, there is provided a technique capable of economically and safely operating an apparatus by allowing wafers made of different materials to be accommodated together.

### [Technical Solution]

According to an embodiment of the present disclosure, there is provided a technique that includes: a mapping apparatus configured to determine a material of a substrate accommodated in a carrier and loaded into the substrate processing apparatus; and a controller configured to be capable of updating and holding first information on the material of the substrate loaded into the substrate processing apparatus, and capable of controlling the substrate processing apparatus to take out the carrier accommodating the substrate when the first information on the material of the substrate does not satisfy a predetermined condition specified for a current operation mode among conditions specified respectively for a plurality of operation modes.

### [Advantageous Effects]

According to some embodiments of the technique of the present disclosure, it is possible to economically and safely operate an apparatus by allowing wafers made of different materials to be accommodated together.

### [Brief Description of Drawings]

FIG. 1 is a diagram schematically illustrating a substrate processing apparatus according to embodiments of the present disclosure.
FIG. 2 is a diagram schematically illustrating a perspective view of a cassette stage and a cassette transfer apparatus according to the embodiments of the present disclosure.
FIG. 3 is a diagram schematically illustrating a configuration of a control system for a wafer mapping by a laser sensor.
FIG. 4 is a diagram schematically illustrating a perspective view of a cassette transfer structure according to the embodiments of the present disclosure.
FIG. 5 is a diagram schematically illustrating a perspective view of a comb-shaped sensor and a wafer posture aligner provided on the cassette stage.
FIG. 6 is a flow chart schematically illustrating a wafer detection flow by the laser sensor.
FIG. 7 is a flow chart schematically illustrating a process flow of a substrate processing method according to the embodiments of the present disclosure.
FIG. 8 is a diagram schematically illustrating a boat map displayed on a screen by a main controller.

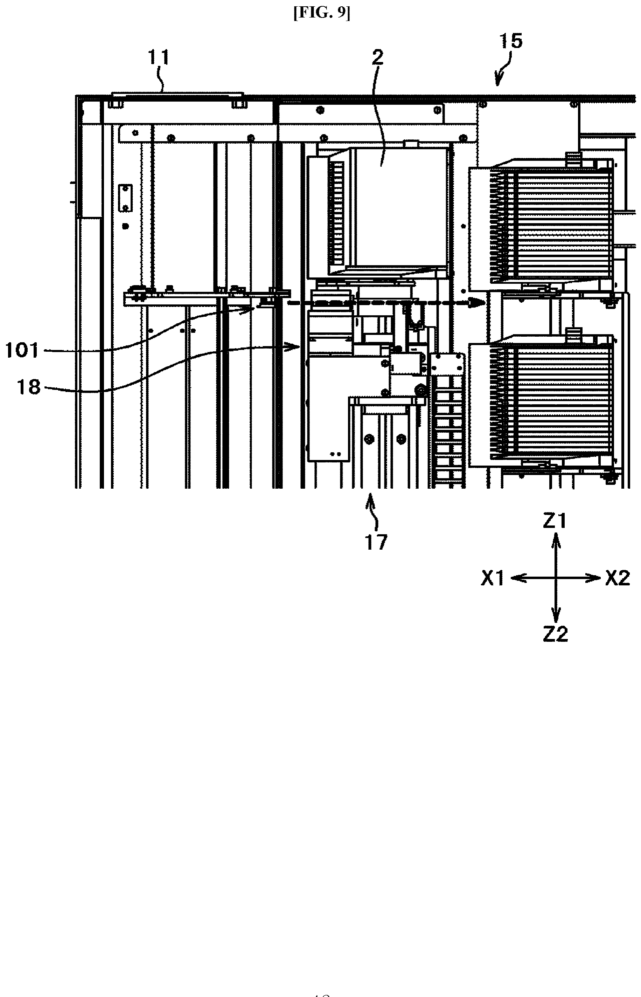

FIG. 9 is a diagram schematically illustrating an arrangement of a laser sensor according to a modified example, wherein a cross-section of a main portion on a side surface of the substrate processing apparatus is shown.

### [Detailed Description]

Hereinafter, embodiments according to the technique of the present disclosure will be described mainly with reference to the drawings. In addition, the drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary. Further, the number of each component described in the present specification is not limited to one, and the number of each component may be two or more unless otherwise specified in the present specification.

### (1) Substrate Processing Apparatus

In the present embodiments of the present disclosure, for example, a substrate processing apparatus (hereinafter, also simply referred to as a "processing apparatus") 10 is configured as a semiconductor manufacturing apparatus capable of performing a processing step in a method of manufacturing a semiconductor device.

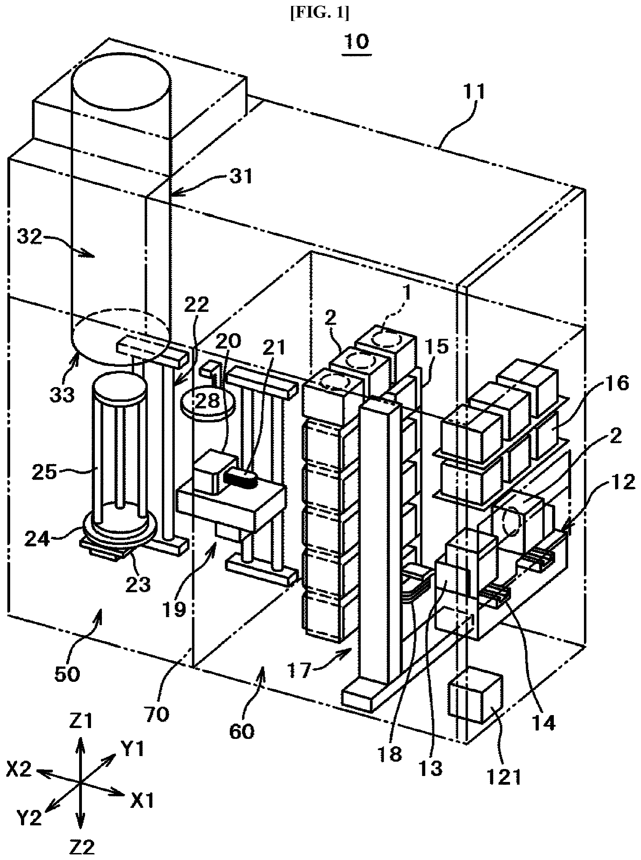

As shown in FIG. 1, the processing apparatus 10 according to the present embodiments includes a housing 11, and an inside of housing 11 is divided by a wall structure 70 into a transfer chamber 50 and a cassette holding chamber 60. A cassette transfer structure 12 is provided adjacent to a front surface of the housing 11, that is, a front surface (in an X1 direction) of the cassette holding chamber 60. In the drawings, an X1-X2 direction indicates a front-rear direction of the processing apparatus 10, a Y2-Y1 direction indicates a left-right direction and a Z1-Z2 direction indicates an up-down direction. The cassette transfer structure 12 is provided with a cassette stage apparatus (also referred to as a "cassette loader" or an "I/O port structure") 13 capable of placing (or mounting) thereon two open cassettes 2 serving as a substrate container. The cassette 2 serves as a carrier for a wafer 1 serving as a substrate. For example, two pairs of wafer posture aligners 14 are provided below the cassette stage apparatus 13. A mounting table 44 (described later) of the cassette stage apparatus 13 receives the cassette 2 transferred by an external transfer apparatus (not shown) in a vertical posture (a state in which the wafers 1 stored in the cassette 2 are vertically arranged).

The mounting table 44 (described later) of the cassette stage apparatus 13 receives the cassette 2 transferred by an external transfer apparatus (not shown) in a vertical posture (a state in which the wafers 1 are accommodated vertically in the cassette 2). The wafer posture aligner 14 is configured to align postures of the wafers 1 such that notches or orientation flats (hereinafter, also referred to as "orientation flats and the like") of the wafers 1 stored in the cassette 2 in the vertical posture are aligned in the same direction. The mounting table 44 is configured to be capable of rotating the cassette 2 by 90 ° between the vertical posture and a horizontal posture (a state in which the wafers 1 are accommodated horizontally in the cassette 2 and an access port of the cassette 2 faces an X2 direction). A cassette shelf 15 is provided in the cassette holding chamber 60 to face the cassette transfer structure 12, and a spare cassette shelf 16 is provided above the cassette transfer structure 12.

A cassette transfer apparatus 17 is provided between the cassette transfer structure 12 and the cassette shelf 15. The cassette transfer apparatus 17 includes a robot arm 18 capable of moving the cassette in the horizontal posture forward and backward in the front-rear direction (X1-X2 direction), and the robot arm 18 itself is configured to be movable laterally (horizontally) and movable up and down. By moving forward and backward (in the front-rear direction), moving up and down and moving laterally, the robot arm 18 transfers the cassette 2 (which is in the horizontal posture on the cassette stage apparatus 13) to the cassette shelf 15 or the spare cassette shelf 16. Each of the cassette shelf 15 and the spare cassette shelf 16 functions as a buffer configured to store the wafers in the cassette used for loading the wafers into the processing apparatus until the wafers are needed.

In the transfer chamber 50, components such as a wafer transfer apparatus 19, a wafer holder 20, a plurality of wafer holding plates 21 and a boat elevator 22 are provided. The wafer transfer apparatus (transfer structure) 19 is installed behind the cassette shelf 15 (in the X2 direction) so as to be rotatable and movable up and down, and transfers the wafers 1 in the cassette 2 to a substrate support (hereinafter, also referred to as a "boat") 25 all at once or one by one. The wafer transfer apparatus 19 includes a forward/backward mover 20 configured to move the plurality of wafer holding plates 21 forward and backward, and can access the cassette 2 (which is in the cassette shelf 15) facing the wafer transfer apparatus 19 through an opening in the wall structure 70.

The boat elevator 22 is provided at a rear (in the X2 direction) of the wafer transfer apparatus 19, and holds (or supports) a seal cap 24 via an arm 23 such that the seal cap 24 can be elevated or lowered.

For example, the processing apparatus 10 includes a reaction tube (also referred to as a "process tube") 31 made of a highly heat resistant material such as quartz and SiC, and the reaction tube 31 is arranged vertically such that a tube axis thereof is vertical. A process chamber 32 in which the wafers 1 are accommodated is constituted by a hollow cylindrical portion of the reaction tube 31. A lower end of the reaction tube 31 is open with respect to the transfer chamber 50 such that a furnace opening 33 through which the wafer 1 is transferred is formed (provided). The furnace opening 33 is closed by the seal cap 24.

The seal cap 24 configured to close the furnace opening 33 is provided to be brought into contact with the lower end surface of the reaction tube 31 from thereunder in the vertical direction. The seal cap 24 is of a disk shape, and is configured to be elevated and lowered in the vertical direction by the boat elevator 22 installed outside the reaction tube 31. In addition, a furnace opening shutter 28 configured to close (or seal) the furnace opening 33 when the seal cap 24 is moved to a lower end position thereof may be further provided.

The boat 25 configured to accommodate (hold or support) the wafers 1 are vertically supported on the seal cap 24. For example, the boat 25 includes a pair of upper and lower end plates 26 and 27 and a plurality of holding structures (support columns) (for example, three holding structures according to the present embodiments) provided vertically between the pair of end plates 26 and 27 so as to connect the pair of end plates 26 and 27. A plurality of support recesses are engraved at each of the holding structures at equal intervals in a lengthwise direction of each of the holding structures. The support recesses located at the same stage of each of the holding structures are open to face one another. By inserting outer peripheral edges of the wafers 1 into the support recesses of the holding structures related thereto, the boat 25 supports (or holds) the wafers 1 while the wafers 1 are horizontally oriented with their centers aligned with one another.

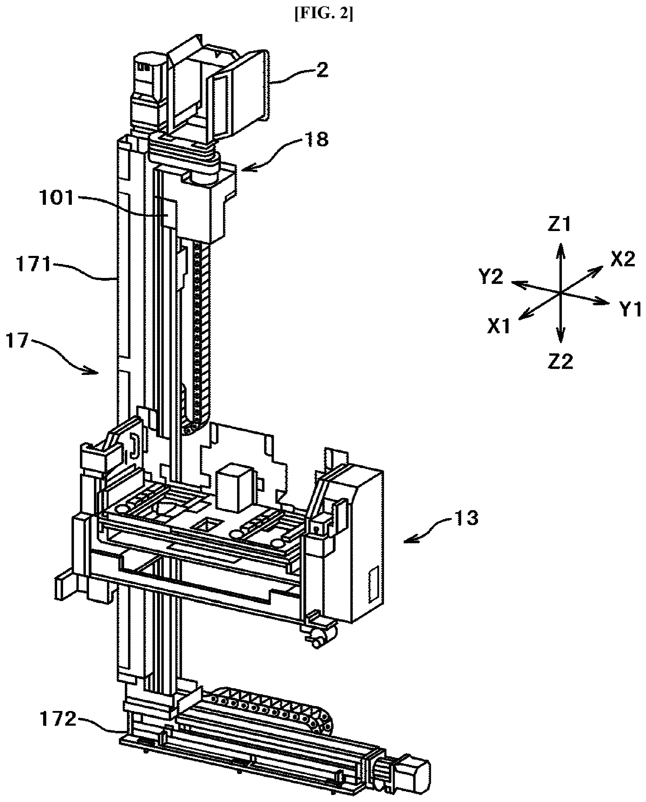

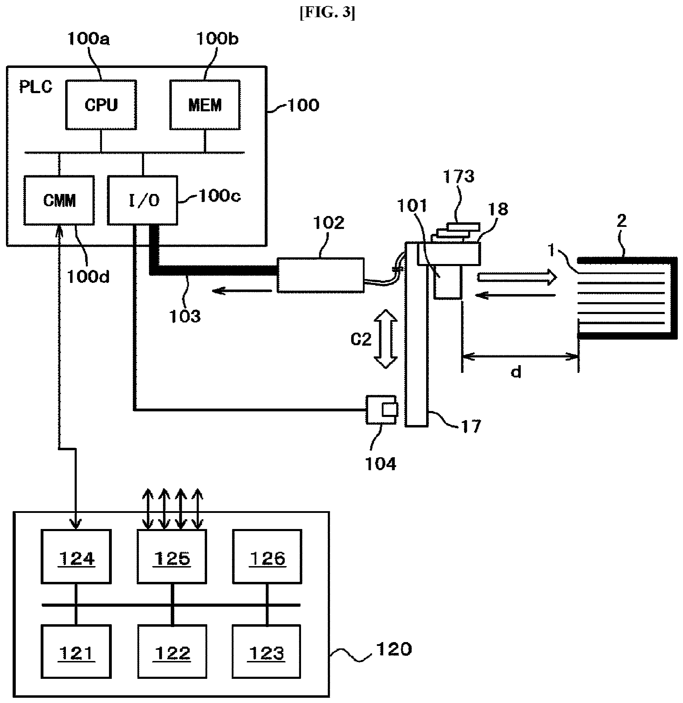

As shown in FIG. 2, the cassette transfer apparatus 17 includes: a CZ driver 171 configured to move the robot arm 18 in the up-down direction (Z1-Z2 direction); and a CS driver 172 configured to move the CZ driver 171 in the left-right direction (Y2-Y1 direction). As a result, by moving forward and backward, moving laterally and moving up and down, the robot arm 18 can access the cassette 2 at any position. As shown in FIGS. 2 and 3, a laser sensor 101 is provided at a base structure of the robot arm 18 to be spaced apart, in the X1 direction, by a predetermined distance (d) from the wafer 1. Alternatively, the laser sensor 101 may be provided on a hand 173 of the robot such that the laser sensor 101 can be movable forward and backward in the front-rear direction. In addition, the wafers 1 stored in the cassette 2 placed on the cassette stage apparatus 13 are in a horizontal state. Therefore, by moving the laser sensor 101 laterally and up and down, it is possible to move the laser sensor 101, in front of the access port of the cassette 2, in an arrangement direction (Z1-Z2 direction) of the wafers 1 stored in the cassette 2, as shown in FIG. 3. The predetermined distance d may vary depending on a diameter of the wafer. However, a range of variation is sufficiently smaller than the predetermined distance d, and is within an operating range of the laser sensor 101. Thereby, it is possible to use the laser sensor 101 commonly for wafers of different diameters, and it is also possible to improve the versatility of the laser sensor 101.

The laser sensor 101 may be a reflection type sensor configured to irradiate a laser light (reference beam) substantially parallel to a main surface of the wafer 1 in a forward direction (X1 direction) and configured to receive the laser light reflected from an end surface of the wafer 1. For example, the laser sensor 101 includes a light projecting circuit, a light projecting element controlled by the light projecting circuit, a light receiving element configured to receive the laser light reflected from the end surface of the wafer 1, and a light receiving circuit configured to output an amount of the laser light received by the light receiving element. It is preferable that the laser sensor 101 is a limited reflection type sensor provided with a detection area that spreads flatly within a plane and within a predetermined distance range. By installing the laser sensor 101 in an orientation such that the "plane" is substantially parallel to the main surface of the wafer 1, it is possible to prevent an erroneous detection due to the laser light reflected from portions other than the wafer 1. In addition, a diameter of the laser light or a thickness thereof when the laser light spreads flat is preferably 5 times or less (for example, 3.5 mm or less) a thickness of the wafer 1 whose half-width is to be detected, and more preferably converged to 0.1 mm or less. Thereby, since a sharp intensity distribution thereof can be obtained, it is possible to determine the thickness of the wafer 1. Although the reflection type sensor has been described as an example of a sensor (that is, the laser sensor 101) attached to the robot arm 18, a transmission type sensor configured to irradiate a reference light in the Y2-Y1 direction and to detect the light (which is not blocked by the wafer 1) may also be used. A trigger sensor 104 detects that the laser sensor 101 has reached a reference position. For example, the reference position is a position where a height of a center of the laser light or the detection area is the same as that of a bottom surface of the cassette 2 when the wafer 1 is in the horizontal state.

A subsidiary controller 100 provided in the processing apparatus 10 will be described with reference to FIG. 3.

The subsidiary controller 100 is constituted by a computer including a CPU (Central Processing Unit) 100a, a memory 100b, an I/O interface 100c and a communication interface 100d. The subsidiary controller 100 may be implemented by an industrial PLC (Programmable Logic Controller).

A control program for controlling an operation of a mapping apparatus is readably stored in the memory 100b. The memory 100b may be embodied by a tangible and computer readable recording medium.

The I/O interface 100c includes components connected to the laser sensor 101 and the trigger sensor 104, such as an analog input interface and a contact input interface. The communication interface 100d serves as a device communicating with a main controller 120 provided in the processing apparatus 10.

An output (current value) of the laser sensor 101 is input to the I/O interface 100c via an amplifier 102 and a cable 103. In addition, an output of the trigger sensor 104 of the cassette transfer apparatus 17 is input to the I/O interface 100c. A second mapping apparatus is constituted by the subsidiary controller 100, the laser sensor 101 and the cassette transfer apparatus 17.

The main controller 120 will be described. The main controller 120 is constituted by a computer including components such as a CPU 121 and a main memory 122.

The CPU 121 reads out a program, a recipe or a WAP (described later) from a subsidiary memory 123 into the main memory 122, and executes the program, the recipe or the WAP. Thereby, the main controller 120 is configured to perform the process based on the recipe by controlling various operations such as a rotation operation of the mounting table 44, a controlling operation of the wafer posture aligner 14, a controlling operation of the robot arm 18 of the cassette transfer apparatus 17, a rotation control and an elevation and lowering control of the wafer transfer apparatus 19, an elevating and lowering operation of the boat elevator 22, a controlling operation of the subsidiary controller 100 via a communication interface 124 and an I/O interface 125. Recipes are prepared for each type of processes performed by the processing apparatus. The main controller 120 may be connected to a higher level control apparatus (not shown) configured to manage a manufacturing process of the semiconductor device so as to be capable of communicating with the higher level control apparatus. The subsidiary memory 123 may include a recording medium such as an optical disk and a USB (Universal Serial Bus) memory.

The main controller 120 can operate the processing apparatus 10 in one mode selected from a plurality of modes (operation modes). In the present example, the plurality of modes includes a high temperature mode (material restriction mode), a low temperature mode (material free mode) and an automatic mode (material selection mode). The high temperature mode is a mode in which a wafer whose usable temperature is lower than a process temperature is not taken into the processing apparatus, the low temperature mode is a mode in which a wafer material (material of the wafer) is not restricted, and the automatic mode is a mode in which the processing apparatus recognizes the wafer material and can place the wafer in an appropriate slot of the boat. Assuming an operation in which a silicon (Si) wafer and a silicon carbide (SiC) wafer are processed together as the wafers, the all wafers in the processing apparatus 10 should be SiC wafers in the high temperature mode, but the all wafers in the processing apparatus 10 may be either SiC wafers or Si wafers in the low temperature mode. For example, the high temperature mode and the low temperature mode can be automatically switched depending on whether the process temperature is higher or lower than an upper limit of a usable temperature of the Si wafers. In addition, the term "usable temperature" means a temperature at which the wafer and the process chamber 32 can be used without being damaged when the wafer is placed in the process chamber 32 and a desired process is performed on the wafer.

An operation mode may be automatically selected in accordance with the process temperature or the WAP set in advance in the main controller 120, or may be manually set through a HMI (Human Machine Interface) 126 regardless of the process temperature. When a cassette containing the Si wafer made of a prohibited material is loaded during the operation in the high temperature mode, the main controller 120 controls the processing apparatus 10 to take out (unload) such a cassette.

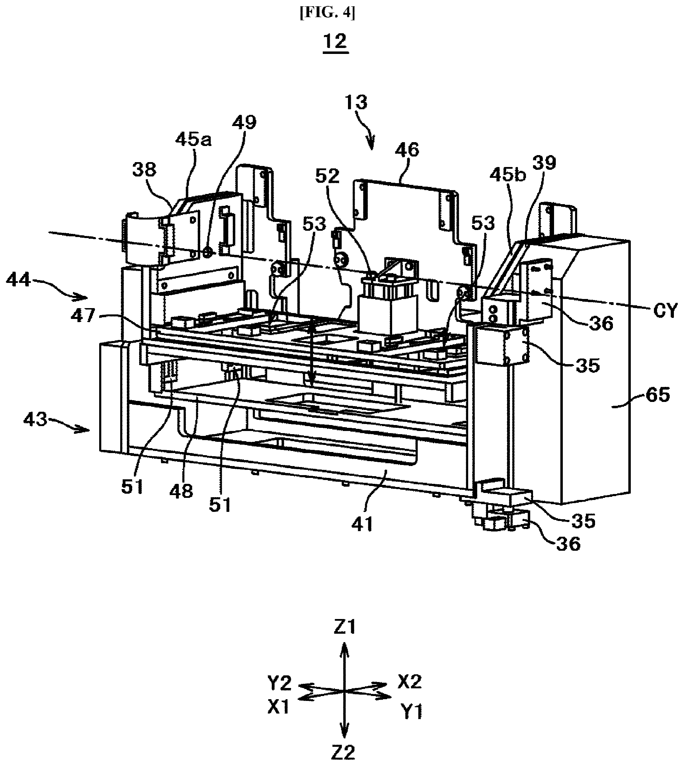

The cassette transfer structure 12 will be described with reference to FIG. 4.

A frame 43 is constituted by fixing a front plate 41 in the X1 direction and a rear plate (not shown) in the X2 direction to a lower portion of a left side plate 38 in a Y2 direction and a right side plate 39 in a Y1 direction. A lower portion of the frame 43 is of a rectangular cylinder shape.

Two hinge structures 35 are, one above the other, fixed to an outer surface of the right side plate 39 at an end of the right side plate 39 adjacent to the front plate 41. Two hinge structures 36 are fixed to a front portion (in the X1 direction) of the housing 11 shown in FIG. 1, and are connected to the two hinge structures 35 corresponding thereto. By the hinge structure 35 which is rotatable around an axis in the Z1-Z2 direction, the cassette stage apparatus 13 is rotatably supported with respect to the housing 11.

A rotating shaft 49 is configured to support the mounting table 44 on the left side plate 38 and the right side plate 39 so as to be rotatable around a CY axis. The mounting table 44 includes a pair of rotating plates 45a and 45b, an internal transfer stage 46, an external transfer stage 47 and a lower plate 48. Each of the rotating plates 45a and 45b is fixed to the rotating shaft 49 on the CY axis, and is rigidly joined by the lower plate 48 provided between the rotating plates 45a and 45b. The mounting table 44 is configured to be rotatable around the rotating shaft 49. The internal transfer stage 46 is fixed to the rotating plates 45a and 45b and/or the lower plate 48. The external transfer stage 47 is attached to the rotating plates 45a and 45b in a horizontal state via a plurality of guides 51 (which is configured to allow a movement in one direction alone) such that the cassette in the vertical posture is movable up and down. An air cylinder 52 is provided between the internal transfer stage 46 and the external transfer stage 47, and is configured to drive the external transfer stage 47 up and down. The two cassettes 2 can be placed on the internal transfer stage 46 or the external transfer stage 47.

Two wafer alignment holes 53 are provided in the external transfer stage 47 with a predetermined interval therebetween. The wafer posture aligner 14 is provided at the lower plate 48 below the wafer alignment holes 53.

A driver (which is a driving structure) 65 configured to rotate the rotating shaft 49 is provided at the outer surface of the right side plate 39. For example, the driver 65 includes components such as an AC servo motor, a worm gear box and a position sensor, and is configured to be capable of rotating the cassette 2 on the mounting table 44 by 90 ° between the horizontal posture and the vertical posture.

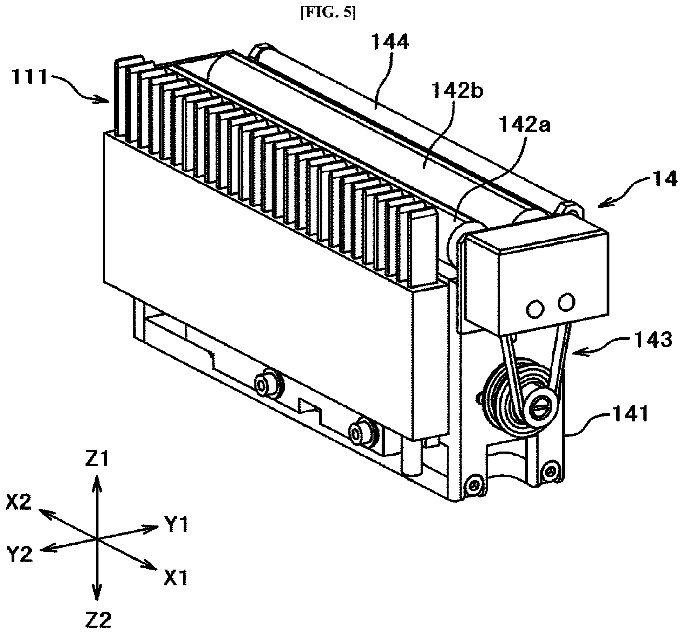

An example of the wafer posture aligner 14 will be described with reference to FIG. 5.

The wafer posture aligner 14 includes a support table 141, a pair of rollers 142a and 142b rotatably spanned over the support table 141 in the horizontal direction, a rotation driver (which is a rotation driving structure) 143 and a stopper 144 provided adjacent to the roller 142b. Each of the pair of rollers 142a and 142b extends in a direction in which a group of the wafers 1 stored in the cassette 2 are aligned (that is, in the X1-X2 direction). The rotation driver 143 is configured to synchronously rotate the rollers 142a and 142b in the same direction. The wafer posture aligner 14 is configured to be movable up and down relative to the cassette 2 placed on the mounting table 44. During an alignment operation, by elevating the wafer posture aligner 14 such that the wafers 1 in the cassette 2 placed on the cassette stage apparatus 13 are in contact with the rollers 142a and 142b and by rotating the wafers 1 in the same direction by the rollers 142a and 142b, the orientation flats between the wafers 1 can be aligned at a constant location. In other words, an orientation flat alignment is mechanically performed by rotating the rollers 142a and 142b such that the wafers 1 are rotated once or more and by regulating a rotation of the wafers 1 by the stopper 144 and idling the rollers 142a and 142b when the orientation flats are aligned. A notch alignment may be performed in a similar manner.

In addition, a comb-shaped sensor 111 is provided at the wafer posture aligner 14 so as not to mechanically interfere with the cassette 2 placed on the cassette stage apparatus 13. The comb-shaped sensor 111 is made of a predetermined material and is configured to detect a presence or absence of the wafer 1 in the cassette 2 before a wafer posture alignment (when the wafer 1 is in the vertical state). The comb-shaped sensor 111 is attached to a side surface of the support table 141 adjacent to the roller 142a (in the Y2 direction) so as to be movable up and down relative to the cassette 2. The comb-shaped sensor 111 is configured to be movable between a detection position and a retracted position so as to be capable of detecting wafers of any size included in detection parameters described later. Thereby, it is possible to commonly use the comb-shaped sensor 111 for the wafers with different diameters, and it is also possible to improve the versatility. A wafer mapping by the comb-shaped sensor 111 is performed in a posture different from that of the cassette 2 in a wafer mapping by the laser sensor 101, which will be described later. Thereby, it is possible to provide the comb-shaped sensor 111 at a location different from that of the laser sensor 101.

The comb-shaped sensor 111 is configured as a comb-shaped structure in which a plurality of pairs of transmission type photoelectric sensor, each including a light emitter (which is a light emitting structure) and a light receiver (which is a light receiving structure), are arranged in a number of the wafers 1 capable of being accommodated in the cassette 2 along the arrangement direction of the wafers 1. The light emitter and the light receiver facing each other are configured to detect the presence or absence of each wafer 1 on an optical path between them. For example, the light emitter is constituted by a light emitting diode for a near-infrared light or a visible light. For example, the light receiver is constituted by a phototransistor.

The light emitter is arranged in a manner corresponding to an arrangement area (slot) for the wafer 1, in the present example, corresponding to a side surface of a storage area (slot) for the wafers 1 in the cassette 2. The light receiver is arranged on an incident optical path of the light from the light emitter so as to face the light emitter via the storage area for the wafers 1. When the external transfer stage 47 is lowered, the light emitter and the light receiver are arranged such that a light emitting surface of the light emitter faces a first surface of the wafer 1 and a light receiving surface of the light receiver faces a second surface of the wafer 1 opposite to the first surface. In other words, the comb-shaped sensor 111 is configured to be capable of moving relatively with respect to the cassette 2 on the cassette stage apparatus 13 between the retracted position and the detection position at which the substrate can be detected. The detection position may be a position that can be commonly applied to the wafers of any size. A first mapping apparatus is constituted by the comb-shaped sensor 111 and the air cylinder 52. The first mapping apparatus and the second mapping apparatus may also be collectively referred to as a "mapping apparatus".

The comb-shaped sensor 111 is configured as a transmission type sensor configured to irradiate the wafer 1 with the reference light and configured to detect the light passing through the wafer 1. In a case where the wafer 1 is configured as a non-transparent wafer (for example, a silicon wafer), the light receiver receives (detects) the light (that is, the reference light) emitted from the light emitter when the wafer 1 is not present, and the light receiver does not receive (detect) the light (that is, the reference light) emitted from the light emitter when the wafer 1 is present. Thereby, it is possible to detect the presence or absence of the wafer 1. However, the presence or absence of the wafer 1 is actually determined by a threshold value processing (which is designed for the silicon wafer whose light transmittance of the reference light is 0) of an amount of the light received by the light receiver. In addition, in a case where the wafer 1 is configured as a transparent wafer (for example, a quartz wafer), since an amount of the light received by the transparent wafer exceeds a threshold value, it is not possible to determine the presence or absence of the wafer 1. Further, when the wafer 1 is configured as a wafer such as the SiC wafer whose light transmittance is about in the middle between that of the silicon wafer and that of the quartz wafer, it is not possible to guarantee a detection of the SiC wafer. Further, there is no space left in an opening on a bottom of the cassette 2 to accommodate a comb-shaped sensor designed for the SiC wafer.

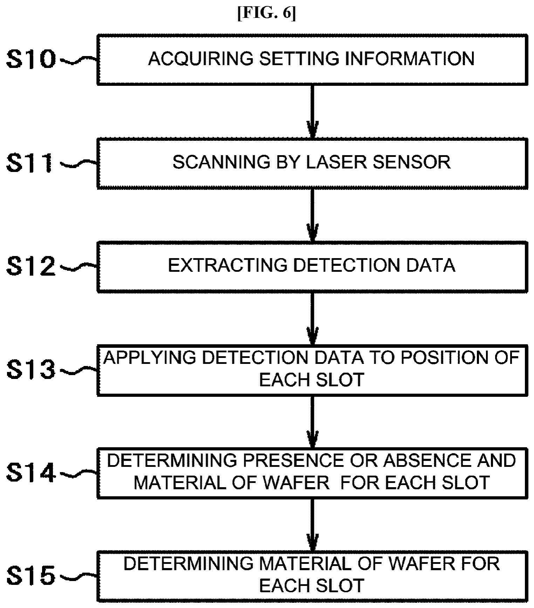

According to the present embodiments, the presence or absence of the wafer or a wafer type is determined by combining the detection by the comb-shaped sensor 111 and the laser sensor 101. Hereinafter, the wafer mapping using the laser sensor 101 will be described with reference to FIG. 6 and Tables 1 to 3. In the following description, the wafer mapping is performed under a control of the main controller 120 and the subsidiary controller 100.

### <Step S10>

The main controller 120 prepares information on a cassette type and the presence or absence of the wafer 1 and the wafer type in each slot as setting information for the cassette 2 inserted as described above. A source of such information, which will be described in detail later, may be notified each time from the higher level control apparatus of the processing apparatus 10, may be set in advance as the WAP (wafer arrangement parameters) in the processing apparatus 10, or may be input by a person when the cassette is inserted. As a result, the size and the material of each wafer 1 in the cassette 2 are specified, and master data corresponding thereto is read from tables shown in Tables 1 and 2. The master data is a parameter for detecting the wafer from a sensor output obtained in time series by an elevating and lowering operation of the laser sensor 101, and is created empirically based on the sensor output and detection results when a normal detection was previously performed, and is registered for each combination of the size and the material. Thereby, it is possible to configure a general-purpose sensor system simply by replacing the master data.

The master data is configured by a cassette table shown in Table 1 and a detection parameter table shown in Table 2. First, the cassette table will be described. As shown in Table 1, the cassette table specifies specifications of the cassettes that differ for each wafer size. The term "Cassette" in a first column is a name for identifying the cassette, which are listed in Table 1 as "A" to "D". The term "Number of slots" in a second column of Table 1 is the number of slots. The term "Slot spacing" in a third column of Table 1 is a width of the slot (also referred to as a "pitch), in units of 0.05 mm. For example, "127" in the "Slot spacing" means 6.35 mm. The term "Reference slot height" is a height of a lowest slot from a lower end of the cassette 2, in units of 0.05 mm.

**[Table 1]**

| Cassette | Number of slots | Slot spacing | Reference slot height | Remarks |
|---|---|---|---|---|
| A | 25 | 127 | 508 | 200 mm standard |
| B | 25 | 95.2 | 290.8 | 150 mm standard |
| C | 25 | 95.2 | 279.4 | 125 mm standard |
| D | 26 | 127 | 508 | 200 mm |
| E | 26 | 127 | 508 | 150 mm |
| ... | ... | ... | ... | ... |

### <Step S11>

The main controller 120 moves the robot arm 18 to a position slightly below the trigger sensor 104 as appropriate, and instructs the subsidiary controller 100 to prepare for scanning. Thereafter, the robot arm 18 is elevated at a constant speed. The subsidiary controller 100 turns on a light emission of the laser sensor 101, and starts sampling a reception intensity of the light received by the laser sensor 101 when the trigger sensor 104 such as a dog sensor detects that the reference position has been reached. Since the laser sensor 101 is the reflection type sensor, the reception intensity of the light (that is, an amount of the light received by the laser sensor 101) is high where the wafer 1 is present, and is low where the wafer 1 is not present. Such data is acquired as scan data. In the present example, a minimum drive unit, an elevation speed and a sampling rate of the CZ driver are designed such that the data on the reception intensity of the light is acquired at intervals of 0.05 mm. Thus, it is possible to achieve a position resolution in a height direction of 0.05 mm, as described later.

### <Step S12>

The main controller 120 performs threshold value processing (binarization processing) on the scan data acquired from the subsidiary controller 110, and extracts a section where the scan data continuously exceeds a threshold value as detection data. The detection data corresponds to the thickness of the wafer 1. The threshold value used in the present step is common to an entirety of combinations of a substrate size and a substrate material. This is because the reflection intensity from an end face is relatively less dependent on the substrate size and the substrate material.

### <Step S13>

A position of each slot is calculated by referring to the cassette table of the master data shown in Table 1, and the detection data obtained in the step S12 is applied to each slot. In addition, more specifically, the cassette is first identified by referring to the master data shown in Table 2, and then the cassette table is referenced.

### <Step S14>

From the detection data for each slot, the presence (ON)/absence (OFF)/an abnormality of wafer 1 for each slot is determined by referring to the detection parameter table of the master data shown in Table 2. When there is no detection data for a slot, it is determined that there is no wafer 1 in the slot. When there are a plurality pieces of detection data for a slot or the detection data for a slot is not within an allowable range of the detection parameter table, it is determined that the slot is abnormal.

**[Table 2]**

| Cassette | Number of slots | Slot spacing | Reference slot height | Remarks |
|---|---|---|---|---|
| A | 25 | 127 | 508 | 200 mm standard |
| B | 25 | 95.2 | 290.8 | 150 mm standard |
| C | 25 | 95.2 | 279.4 | 125 mm standard |
| D | 26 | 127 | 508 | 200 mm |
| E | 26 | 127 | 508 | 150 mm |
| ... | ... | ... | ... | ... |

As shown in Table 2, the detection parameter table holds parameters for the wafer type, that is, for each combination of the wafer material and the wafer size, and the term "Registration. No." in a first column of the Table 2 is configured to uniquely identify the wafer type. The parameters are quantitatively given from a pattern of the reception intensity of the light obtained by repeatedly performing the step S11 for the wafer 1 (which is known) normally stored in a slot of the cassette 2. For example, a standard light receiving pattern is obtained by averaging a plurality pieces of scan data of the reception intensity of the light. In the pattern, a wafer lower reference value (lower boundary value) can be defined as a position at which the reception intensity of the light crosses the threshold value while increasing, that is, a lower end of the wafer 1, a wafer upper reference value (upper boundary value) can be defined as a position where the reception intensity of the light crosses the threshold value while decreasing, that is, an upper end of the wafer 1, and a peak intensity can be defined as a maximum reception intensity of the light between the lower boundary value and the upper boundary value. The term "intermediate position offset" can be defined as a distance by which an intermediate position of an interval where the reception intensity of the light exceeds the threshold value is shifted from a slot position of the cassette 2.

The term "upper boundary - lower boundary interval (min)" in a fifth column of the detection parameter table is a lower limit of a difference between the upper boundary value and the lower boundary value for each wafer type. Similarly, the term "upper boundary - lower boundary interval (max)" in a sixth column is an upper limit of the difference. Such values are calculated and registered based on an average of the pattern or a standard deviation of the pattern.

The term "peak intensity (min)" in a seventh column and the term "peak intensity (max)" in an eighth column are lower and upper limits of the peak intensity for each wafer type, respectively, and are calculated and registered based on an average, a standard deviation or a measured minimum or maximum values of the peak intensity.

The term "intermediate position offset (min)" in a ninth column and the term "intermediate position offset (max)" in a tenth column are lower and upper limits of the intermediate position offset for each wafer type, respectively, and are calculated and registered based on an average, a standard deviation or a measured minimum or maximum values of the intermediate position offset. The intermediate position offset may include half the thickness of the wafer as a positive biasing factor, and a bending amount of the wafer as a negative biasing factor.

The "peak center shift (max)" in an eleventh column is a value indicating an upper limit of a difference (absolute value) between a position of the peak intensity and the intermediate position of the interval where the reception intensity of the light exceeds the threshold value for each wafer type, and is calculated and registered based on an average value, a standard deviation and the like of the value. A peak appears when an optical axis of the laser sensor 101 is perpendicular to an edge of the wafer. For the wafer with the edge of a general shape, such a difference is distributed around zero (0). A shift that exceeds the peak center shift (max) suggests an abnormality such as a tilt of the wafer.

As shown in Table 2, the detection parameter table registered as described above includes "material", "size" and "cassette" in addition to the parameters mentioned above. In the present specification, the term "material" is the material of the wafer 1, such as silicon (Si) and silicon carbide (SiC). The term "size" is the diameter of the wafer 1, and is measured in units of mm.

In addition, the values "upper boundary - lower boundary interval (min)", "upper boundary - lower boundary interval (max)", "peak intensity (min)", "peak intensity (max)", "intermediate position offset (min)", "intermediate position offset (max)" and "peak center shift (max)" are given in units of 0.05 mm. For example, "11" in the "upper boundary - lower boundary (min)" means 0.55 mm obtained by multiplying 11 by 0.05 mm.

The detection parameters mentioned above are acquired in advance for a plurality of combinations of the wafer size and the wafer material and the cassette, and are stored in the memory of the main controller 120 or the memory 100b of the subsidiary controller 100 in a data structure shown in Table 2.

Returning to FIG. 6, in the step S14, by referring to the cassette type and the wafer type of each slot acquired in the step S11, the detection parameters are appropriately switched for each slot to determine whether or not the detection data is within the allowable range of the detection parameters. When one or more items are outside the allowable range, the subsidiary controller 100 determines that the slot is abnormal and issues a warning. In addition, a level of the warning may be varied depending on the item that is outside the allowable range or the number of such items. In addition, basically, the detection parameters corresponding to the setting information are used. However, when the abnormality occurs due to such parameters, the detection parameters for the wafer of the same size but different material may be used to determine whether or not the detection data is within the allowable range. When it is determined that the detection data is within the allowable range (that is, "ON"), they may be adopted as final values.

### <Step S15>

The wafer material (wafer type) is determined for each slot using a determination table shown in Table 3. When the wafer mapping by the laser sensor 101 is determined to be "ON" and the wafer mapping by the comb-shaped sensor 111 is determined to be "ON", the material of the wafer 1 is determined to be silicon (Si). When the wafer mapping by the laser sensor 101 is determined to be "ON" and the wafer mapping by the comb-shaped sensor 111 is determined to be "OFF", the material of the wafer 1 is determined to be silicon carbide (SiC). When the wafer mapping by the laser sensor 101 is determined to be "OFF" and the wafer mapping by the comb-shaped sensor 111 is determined to be "OFF", it is determined that the wafer 1 is not present.

**[Table 3]**

| | Laser Sensor | Comb-shaped sensor |
|---|---|---|
| Si wafer | ON | ON |
| SiC wafer | ON | OFF |
| Wafer is not present | OFF | OFF |

When the wafer size is known, the thickness of the wafer 1 may be determined from the detection data extracted in the step S12, and the material of the wafer 1 may be determined by referring to information associating the thickness of the wafer 1 with the material of the wafer 1 (detection parameter data shown in Table 2). In addition, in the example shown in Table 2, the material may be determined by the peak intensity alone, but there is a case where such a determination is difficult. When the material can be judged by the wafer thickness or the peak intensity, the comb-shaped sensor 111 may not be used, and the presence or absence and the material of the wafer 1 may be determined by the laser sensor 101 alone.

Before describing the processing step, the wafer type and the cassette type (also referred to as a "carrier type") will be described according to their applications.

In a batch type processing apparatus, in addition to a product wafer serving as a wafer from which a device (which actually becomes a product) is obtained, several wafers for specific applications are placed in a boat at the same time. For example, dummy wafers placed above and below an arrangement region of product wafers, or monitor wafers placed in a center or at an end of the arrangement region of the product wafers to inspect a film forming result may be present. In addition to dummy wafers in the narrow sense, which should always be placed, the dummy wafers may further include: fill dummies that fill slots of the boat instead of the product wafers when constantly processing the product wafers less than a maximum number that can be placed; or adjustment dummies that are used temporarily when there are even fewer product wafers.

The cassette may be a special purpose carrier storing wafers for one of the applications mentioned above alone, or may be a mixed type carrier storing wafers for different applications that are placed in the boat together in one execution of a batch process. Assuming that the special purpose carrier alone is used, for example, four product wafer cassettes (P01, P02 and P03) including three carrier types, one dummy wafer cassette (S01) and one monitor wafer cassette (M01) are used to perform one execution of the batch process. Such a cassette may be referred to as a "virtual carrier" or a "logical carrier", and are defined as alias information associated with the carrier types such as "product", "dummy" and "monitor". The main controller 120 holds the alias information by linking the virtual carrier to information indicating the wafer type and the wafer material, assuming that the virtual carrier stores the wafers of a single material alone.

Even when the mixed type carrier is used, a "virtual carrier" is similarly defined by associating such a cassette with the carrier type corresponding to a majority wafer type. In addition, for each virtual carrier, a slot map is defined to indicate which slot stores which wafer for which purpose and material, and the main controller 120 stores the alias information linked to the slot map. The slot map may be identified based on a mapping by the processing apparatus itself, without prior information.

The alias information or the slot map may be stored in advance in the main controller 120 as a part of the information constituting the WAP, or may be notified from the higher level control apparatus of the processing apparatus 10. The WAP depends on contents of a substrate processing. In other words, the WAP is linked to each recipe.

### (2) Substrate Processing

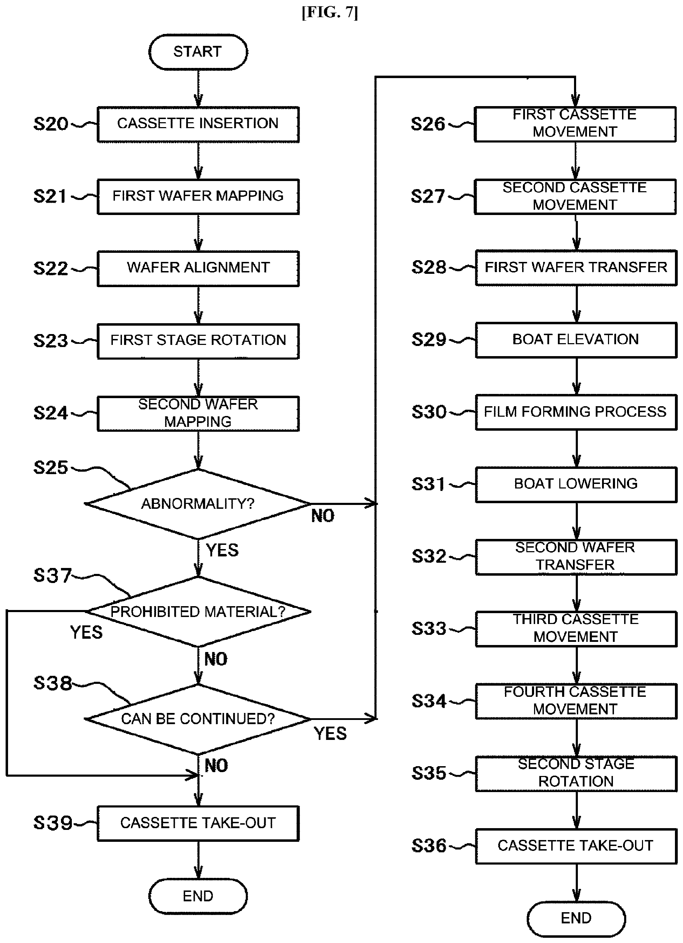

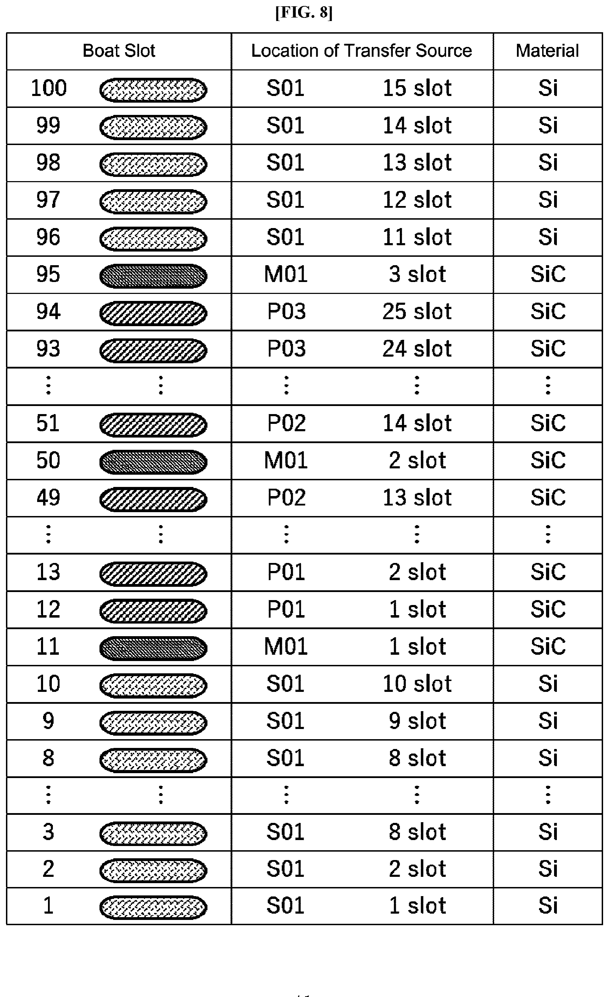

Subsequently, a substrate processing method using the reaction tube 31 of the processing apparatus 10 will be described with reference to FIGS. 7 and 8. The substrate processing method mentioned above will be described by way of an example in which a step in the manufacturing process of the semiconductor device (for example, a film forming process in which a film is formed on the wafer 1) is performed by using the reaction tube 31 of the processing apparatus 10 described above. In the following description, operations of components constituting the processing apparatus 10 are controlled by the main controller 120.

### <Cassette Insertion: S20>

The cassette 2 charged (loaded) with wafers (which are unprocessed) 1 is placed on the cassette stage apparatus 13 of the cassette transfer structure 12 with a help of the external transfer apparatus (not shown) or a person. The wafers 1 in the cassette 2 are in the vertical state. In addition, in such a time, information indicating which virtual carrier is associated with the cassette placed on the cassette stage apparatus 13 or indicating the material of each wafer 1 stored in the cassette is given from the higher level control apparatus or a person.

### <First Wafer Mapping: S21>

First, after the cassette 2 is placed on the cassette stage apparatus 13, the wafer mapping is performed by the comb-shaped sensor 111. In such a time, the wafers 1 in the cassette 2 are in the vertical state. In addition, when the wafer material can be determined in a second wafer mapping (S24), the present step may be omitted.

### <Wafer Alignment: S22>

Then, the wafers 1 are aligned by the wafer posture aligner 14 using the orientation flats and the like.

### <First Stage Rotation: S23>

Subsequently, by rotating the cassette stage apparatus 13 by 90 degrees, the cassette 2 is also rotated by 90 degrees backward. The wafers 1 in the cassette 2 are converted into the horizontal state.

### <Second Wafer Mapping: S24>

Subsequently, when the wafers 1 are in the horizontal state in the cassette stage apparatus 13, the steps S10 to S15 shown in FIG. 6 are performed. The main controller 120 updates and holds (stores) a result (material information) as first information. Thereby, it is possible to grasp the material of the all wafers in the all cassettes currently in the processing apparatus 10. In other words, no matter how the cassette is moved to the cassette shelf 15 thereafter, the material information acquired in the step S24 is linked so as to be capable of being referenced. When the cassette is a mixed type carrier without the slot map, the material information in the step S24 serves as the slot map for such a cassette.

### <Abnormality Determination: S25>

When the processing apparatus 10 is operated in a high temperature mode and the wafer determined in the step S24 contains the prohibited material (Si), it is determined to be abnormal, and the process branches to a step S36. For example, when there is a slot in which the material or the presence or absence of the wafer 1 specified from virtual carrier information given in the step S20 does not match the material or the presence or absence of the wafer 1 determined in the step S24, it is determined to be abnormal, and a process of the substrate processing method branches to a step S37. Otherwise, it is determined to be normal, and the process proceeds to a step S26. It may also be said that, in the step S25, whether or not the material of the substrate satisfies substrate arrangement information is determined when the substrate in the carrier (corresponding carrier) associated with the virtual carrier and loaded into the processing apparatus 10 is transferred to a substrate holder (that is, the wafer holder 20) based on map information. In addition, when the operation mode is the low temperature mode, the step S24 may be omitted, and the abnormality may be determined by comparing the presence or absence of the wafer 1 alone based on a result of the step S21.

### <First Cassette Movement: S26>

Subsequently, the cassette 2 is held (supported) by the robot arm 18, and the cassette 2 is transferred by the robot arm 18 to the cassette shelf 15 or the spare cassette shelf 16 and stored temporarily. The cassette associated with the virtual carrier may be stored at a position such as the cassette shelf 15 that is fixedly assigned to the virtual carrier.

### <Second Cassette Movement: S27>

When a certain batch process is started, the main controller 120 controls the robot arm 18 to sequentially move the cassettes respectively associated with virtual carriers from the cassette shelf 15 or the spare cassette shelf 16 to a transfer shelf located on the cassette shelf 15 opposite to the wafer transfer apparatus 19.

### <First Wafer Transfer: S28>

The wafers 1 in the cassette 2 placed on the transfer shelf are sequentially transferred to the boat 25 by the wafer transfer apparatus 19. In such a time, the main controller 120 controls the wafer transfer apparatus 19 by referring to a boat map serving as the map information indicating which substrate in each slot of which virtual carrier should be transferred to which boat slot. The boat map may be defined in advance by the direct specification, or may be dynamically generated based on the WAP. The substrate arrangement information is constituted by the boat map and the WAP.

When instructed to display the boat map, the main controller 120 displays a map such as an example shown in FIG. 8 on the HMI 126. A left column of the map indicates a boat slot number and an icon of the wafer to be placed. The icon is arranged side by side with the boat slot number. A center column of the map indicates information for identifying a transfer source, that is, a name (identifier) of the virtual carrier and a slot number in such a carrier. A right column of the map indicates the material of the wafer to be transferred. In addition, the icon of the wafer is displayed with a color or pattern in accordance with a type of the virtual carrier and the material of the wafer, and is not displayed when there is no wafer to be placed. From FIG. 8, it can be seen that one of the slots of the plurality of virtual carriers is uniquely associated with each of the transfer sources by the boat map.

In addition, the virtual carrier referenced by the substrate arrangement information and the information on the material of the wafer accommodated in the virtual carrier are linked by the alias information and the like, and it is confirmed in the step S25 that the information on the material matches the first information. As a result, the substrate arrangement information and the first information are ultimately linked. In other words, a wafer transfer is performed with the material thereof correctly identified. The WAP is a general term for parameters defining a relationship between the wafer type and the boat slot for the wafer to be placed in a more conceptual way than by direct specification. By using the WAP, a remaining wafer in the cassette that is not used in a previous batch process can be dynamically determined as the wafer to be transferred. It is sufficient as long as the wafer type can be identified by the WAP, and the wafer material may not be identified by the WAP. Similarly, instead of storing the slot map of the cassette as data that corresponds one-to-one with the slots, the slot map of the cassette may be stored as CAP (cassette arrangement information) that collectively defines the wafer type for a plurality of consecutive slots.

### <Boat Elevation: S29>

Subsequently, the boat 25 is loaded into the reaction tube 31 by the boat elevator 22.

### <Film Forming Process: S30>

After the boat 25 is loaded into the reaction tube 31, an inner atmosphere of the process chamber 32 is controlled such that an inner pressure of the process chamber 32 reaches and is maintained at a predetermined pressure. In addition, an inside of the process chamber 32 is controlled such that an inner temperature of the process chamber 32 reaches and is maintained at a predetermined temperature using a heater. For example, a source gas and a reactive gas are supplied into the process chamber 32 to form the film on the wafer 1.

### <Boat Lowering: S31>

After the film forming process is performed, the boat 25 is taken out from the reaction tube 31 by the boat elevator 22 (that is, the boat 25 is unloaded).

### <Second Wafer Transfer: S32>

Subsequently, the wafers 1 (which are processed) in the boat 25 are sequentially transferred into the cassette 2 on the transfer shelf by the wafer transfer apparatus 19. Usually, the wafers are returned to the slots of the cassette in which the wafers were originally stored before transferred into the boat, with reference to the boat map used in the step S28.

### <Third Cassette Movement: S33>

Subsequently, the cassette 2 on the transfer shelf is sequentially moved to the cassette shelf 15 or the spare cassette shelf 16 by the robot arm 18.

### <Fourth Cassette Movement: S34>

When the cassette 2 is transferred (unloaded) out of the processing apparatus 10, the cassette 2 is transferred from the cassette shelf 15 or the spare cassette shelf 16 to the cassette stage apparatus 13 of the cassette transfer structure 12 using the robot arm 18.

### <Second Stage Rotation: S35>

Subsequently, the cassette 2 is rotated by 90 degrees by the cassette stage apparatus 13 such that the access port thereof faces upward.

### <Cassette Take-out: S36>

Thereafter, the cassette 2 is taken out and transferred outside the housing 11 by the external transfer apparatus.

### <Prohibited Material Determination: S37>

When the processing apparatus 10 is operated in the high temperature mode and contains a wafer of a prohibited material (Si), it is determined that the cassette 2 determined in the step S24 needs to be taken out, and the process branches to a step S39.

### <Abnormality Type Determination: S38>

An appropriate action is selected depending on whether the abnormality is a material mismatch, a missing wafer or other (excess wafers and the like). Specifically, when the WAP is specified directly and there is the material mismatch or the missing wafer, it is determined that the current batch process cannot be continued, and the process proceeds to the step S39. When the WAP is not specified directly, in other words, a dynamic placement is possible, it is determined that the current batch process can be continued, and the process returns to the step S26. In such a case, the boat MAP is modified such that the wafers or the cassettes that are missing due to the mismatch or other reasons are replaced with other wafers or cassettes of the same type. When there are not enough wafers or cassettes to be replaced, an alarm is sounded to prompt an insertion of the cassettes 2, and the process may be interrupted until a sufficient amount is inserted.

### <Cassette Take-out: S39>

When the material is determined to be prohibited in the step S37 or when it is determined that the process cannot be continued in the step S37, such a cassette is taken out (removed). That is, by controlling the cassette stage apparatus 13, the cassette 2 is rotated by 90 degrees such that the access port thereof faces upward and the cassette 2 is capable of being taken out, and an alarm or the like is sounded to prompt the external transfer apparatus or the like to take out the cassette on the cassette stage apparatus 13 from the housing 11. The cassette to be removed is the cassette determined to be abnormal in the step S25, or a set of the cassettes to be used in the corresponding batch process, including the cassette determined to be abnormal. The alarm is not cleared until a target cassette (that is, the cassette determined to be abnormal) is taken out or some kind of a recovery operation is performed. However, even during the alarm, when the set of the cassettes to be used in a subsequent batch process is already stored on the cassette shelf 15 and the like, it is possible to continue with the subsequent batch process. In addition, when the cassette of the same type as the cassette 2 that is taken out is specified or inserted as a replacement, the current batch process can be continued.

Since the cassettes 2 for two executions of the batch process can be stored on the cassette shelf 15 and the like, in an actual operation of the apparatus, the cassette 2 for the previous batch process is taken out during the current batch process, and then the cassette 2 for the subsequent batch process is inserted. In a case where the abnormality is detected by performing the wafer mapping when the cassette 2 for the subsequent batch process is inserted, the alarm is issued to advise a take-out (removal) of the cassettes 2, but the current batch process (which is being processed) can be continued. In addition, the time for taking out and the time for reinserting the cassette 2 overlap with the process time of the current batch process. Thus, the productivity is not affected thereby.

In addition, the take-out in the step S39 may be postponed. That is, the cassette may be temporarily stored on the cassette shelf 15 and the like, after being set to be unselectable in the batch process by canceling an association with the virtual carrier. Thereby, it is possible to avoid impeding an insertion of a subsequent cassette. In addition, an abnormality determination in the step S25 may be postponed until the mapping (the step S24) of the all virtual carriers for one batch process is completed.

According to the present embodiments, it is possible to obtain one or more effects described below.
(a) During the operation in the high temperature mode (material restriction mode), it is possible to ensure that no wafer of the prohibited material is present in the processing apparatus 10 except on the cassette stage apparatus 13, and it is also possible to reliably prevent a damage to the wafers and the process chamber 32 caused by loading and processing the wafer of the prohibited material into the process chamber 32. For example, in a process chamber where the SiC wafers are processed at a high temperature of 1,500°C or higher, the Si wafers may melt. Therefore, it is preferable to prevent the SiC wafers and the Si wafers from being accommodated together in the cassette 2.
(b) During the operation in the automatic mode (material selection mode), it is possible to recognize the wafer material and it is also possible to transfer the wafer from the I/O port structure of the processing apparatus to the boat. Thereby, it is possible to operate the processing apparatus flexibly and efficiently by using the special purpose carrier configured to store the wafers of one material or the mixed type carrier configured to store the wafers of a plurality of materials. For example, by transferring the wafer provided by the virtual carrier to the appropriate slot of the boat, it is possible to operate the processing apparatus as an apparatus capable of processing the wafers of the plurality of materials.
(c) During the operation in the low temperature mode (material free mode), it is possible to maintain a full backward compatibility for the WAP and the recipe which do not restrict material. In other words, when the cassette properly accommodating the wafers of different materials is prepared in advance and the process temperature is set correctly in accordance with a material whose upper limit of the usable temperature is lowest, it is possible to perform the operation in which the wafers of different materials are provided together. In addition, it is preferable to provide an interlock configured to prevent an execution of the recipe that exceeds a typical upper limit of the usable temperature (for example, 1,400 °C) during the operation in the low temperature mode.
(d) It is possible to distinguish the SiC wafers between the Si wafers for side dummies stored in a single cassette 2. Thereby, it is possible to operate the mixed type carrier. In other words, as long as the process temperature is below the usable temperature for some or the all side dummies placed adjacent to upper and lower ends of the boat 25, it is possible to use silicon (Si) bare wafers (wafers without patterns formed thereon), which are cheaper than the SiC wafers. As a result, it is possible to operate the processing apparatus economically.
(e) In an apparatus configured to operate by switching between a plurality of recipes, the WAP is selected in accordance with the recipe, and the material of the wafer to be transferred to the boat 25 is specified by the WAP. Thereby, it is possible to automatically switch the operation mode based on the material and the process temperature. For example, when there are a recipe for processing the Si wafer alone and a recipe for processing the SiC wafer alone, the former is operated in the low temperature mode and the latter in the high temperature mode. As a result, it is possible to use the apparatus capable of processing both the SiC wafer and the Si wafer, and it is possible to further improve an operating rate of the apparatus.
(f) The laser sensor 101 is a scanning type sensor, and since the determination is based on a comparison with the master data, it is possible to detect the presence or absence of the wafer regardless of the substrate material. Thereby, it is possible to detect positions of a plurality types of substrates without changing a hardware related thereto. In other words, a software related thereto can handle differences in the substrate size and the pitch of the cassette.
(g) Since the determination is based on the comparison with the master data, it is possible to detect abnormalities such as deformation of the cassette as well as the abnormality of the substrate.
(h) Since the laser sensor 101 can be provided on a location such as the robot arm 18 (which is configured to be movable up and down) of the cassette transfer apparatus 17, there is no need to add a separate motion axis for the wafer mapping.
(i) Since the laser sensor 101 uses an end face reflection type sensor, it is possible to detect the presence or absence of the substrate such as a substrate whose transmittance is high (for example, quartz wafer), a transparent substrate whose transmittance changes due to a film formation (for example, the SiC wafer) and a substrate whose transmittance is low (Si wafer) by using a single end face reflection type sensor.
(j) Since the thickness of the substrate can be measured based on the reception intensity of the light of the reflection type sensor, it is possible to distinguish the substrate material based on the difference in the thickness of the substrate.
(k) Since the reflection type sensor is used, there is no need to insert the reflection type sensor above, inside or below the cassette during the detection. Thereby, there are no restrictions on a size of a sensor head of the reflection type sensor.
(l) By the two types of the wafer mapping (the laser sensor of a reflection type and the comb-shaped sensor of a transmission type), it is possible to distinguish the substrate material (between the Si wafer and the SiC wafer or between the Si wafer and the quartz wafer). Thereby, there is no need to prepare a dedicated comb-shaped sensor for each substrate material to distinguish the substrate material. As a result, it is possible to prevent the cassette stage from becoming too large.

Another type of a processing apparatus will be described with reference to FIG. 10. The laser sensor 101 is fixed to a front portion (in the X1 direction) of the housing 11 of the processing apparatus 10 with respect to the cassette transfer apparatus 17. In other words, the laser sensor 101 is fixed to the housing 11 opposite to the cassette shelf 15 with respect to the cassette transfer apparatus 17. As shown by a dashed arrow in FIG. 10, the optical axis of the laser sensor 101 is fixed in the horizontal direction, and the reference light is irradiated in the X2 direction. That is, the laser sensor 101 irradiates the reference light onto the cassette 2 on the robot arm 18 of the cassette transfer apparatus 17. By elevating and lowering the cassette 2 by the cassette transfer apparatus 17, the wafer mapping for an inside the cassette 2 is performed. According to the present embodiment, it is possible to obtain substantially the same effects as in the embodiments mentioned above.

According to the embodiments mentioned above, the wafer 1 is fixed and the laser sensor 101 is capable of being elevated and lowered. However, according to the present embodiment, the laser sensor 101 is fixed and the wafer 1 is capable of being elevated and lowered. In other words, the laser sensor 101 is capable of being moved relative to the wafers 1 stored in the cassette 2 along the arrangement direction of the wafers 1.

According to the embodiments mentioned above, the wafer mapping by the laser sensor 101 is performed when the cassette 2 is in the cassette stage apparatus 13. However, according to the present embodiment, the wafer mapping by the laser sensor 101 is performed when the cassette 2 is in the cassette transfer apparatus 17. In either case, the wafer mapping by the laser sensor 101 is performed when the cassette 2 is in a location that cannot be accessed by the wafer transfer apparatus 19, that is, when it is located outside the transfer shelf. Thereby, it is possible to perform the wafer mapping without occupying the transfer shelf or the wafer transfer apparatus. As a result, there is no delay in the wafer transfer. In addition, according to the present embodiment, it is possible to perform the wafer mapping without occupying the cassette stage apparatus 13. Thereby, there is no delay in inserting or removing the cassette.

For example, some of the embodiments mentioned above are described by way of an example in which the laser sensor 101 is used to detect the reflection from the edge of the wafer in the wafer mapping. However, the technique of the present disclosure is not limited thereto. For example, a reflection plate may be placed outside the opening on the bottom of the cassette to detect the light that has made one round trip through a gap between adjacent wafers. In such a case, the present embodiment is substantially the same as the embodiments mentioned above, except that an intensity of a light reception level is reversed.

For example, some of the embodiments mentioned above are described by way of an example in which the laser sensor 101 irradiates the reference light toward a center of the wafer in a lateral center portion, which is closest to the edge of the wafer, that is, detects the reflection from the edge perpendicular to the reference light. However, the technique of the present disclosure is not limited thereto. For example, the presence or absence or the type of wafer may be determined by combining results of scanning performed at a plurality of different positions in the left-right direction (Y2-Y1 direction), or the tilt of the wafer may be determined based on difference in the detected positions.

For example, some of the embodiments mentioned above are described by way of an example in which the batch type substrate processing apparatus capable of simultaneously processing a plurality of substrates is used. However, the technique of the present disclosure is not limited thereto. For example, the technique of the present disclosure may also be preferably applied when a single wafer type substrate processing apparatus capable of processing one or several substrates at a time is used. The single wafer type substrate processing apparatus may not include the cassette shelf or the cassette transfer apparatus. However, even when the single wafer type substrate processing apparatus is used, it is possible to perform the mapping with material discrimination as disclosed in the present disclosure using a substrate transfer structure or other mapping structures in a loading port structure or a vacuum load lock chamber.

Process procedures and process conditions of each process using the substrate processing apparatuses exemplified above may be substantially the same as those of the embodiments mentioned above. Even in such a case, it is possible to obtain substantially the same effects as in the embodiments mentioned above

### [Description of Reference Numerals]

| | | | |
|---|---|---|---|
| 1: | Wafer (substrate), | 2: | Cassette, |
| 100: | Subsidiary controller, | 101: | Laser sensor |
| 111: | Comb-shaped sensor, | 120: | Main controller |

## Claims

1. A substrate processing apparatus comprising:
a mapping apparatus configured to determine a material of a substrate accommodated in a carrier and loaded into the substrate processing apparatus; and
a controller configured to be capable of updating and holding first information on the material of the substrate loaded into the substrate processing apparatus, and capable of controlling the substrate processing apparatus to take out the carrier accommodating the substrate when the first information on the material of the substrate does not satisfy a predetermined condition specified for a current operation mode among conditions specified respectively for a plurality of operation modes.

2. The substrate processing apparatus of claim 1, wherein the mapping apparatus is further configured to determine a first material and a second material whose upper limit of a usable temperature is lower than that of the first material,
the plurality of operation modes comprise a high temperature mode in which all substrates in the substrate processing apparatus are made of the first material and a low temperature mode in which the all substrates in the substrate processing apparatus are allowed to be made of any one of the first material or the second material, and
the controller is further configured to be capable of controlling the substrate processing apparatus to take out the carrier accommodating a substrate of the second material when the substrate of the second material is loaded during an operation in the high temperature mode.

3. The substrate processing apparatus of claim 1, further comprising:
a shelf configured to store the substrate while accommodated in the carrier used when loading the substrate; and
a transfer structure configured to transfer the substrate between the carrier used when loading the substrate and a substrate holder capable of holding a substrate being processed,
wherein the controller is further configured to be capable of holding material information acquired for each slot of each of carriers in the substrate processing apparatus as the first information, capable of storing substrate arrangement information directly or indirectly defining a type of a substrate to be transferred for each slots where the substrate is held by substrate holder, and capable of controlling the transfer structure to transfer the substrate between one of the carriers in the substrate processing apparatus and the substrate holder by associating the first information with the substrate arrangement information.

4. The substrate processing apparatus of claim 1, wherein the controller is further configured to be capable of holding or generating map information by which one of slots of a plurality of virtual carriers serving as transfer sources is uniquely associated with each slot of the substrate holder, and capable of determining whether a substrate in a carrier loaded into the substrate processing apparatus corresponding to one of the plurality of virtual carriers is made of a material that satisfies the substrate arrangement information when transferred to the substrate holder based on the map information.

5. The substrate processing apparatus of claim 4, wherein each of the plurality of virtual carriers is supposed to accommodate substrates made of either a first material alone or a second material alone, and the map information comprises the substrate arrangement information.

6. The substrate processing apparatus of claim 4, wherein the controller is further configured to be capable of: storing alias information by which the plurality of virtual carriers supposed to accommodate substrates made of either a first material alone or a second material alone is associated with a type of the substrate and the substrate arrangement information directly defining the type of the substrate; generating the map information from the alias information and the substrate arrangement information; and transferring the substrate based on the map information.

7. The substrate processing apparatus of claim 3, wherein the type of the substrate handled by the substrate arrangement information comprises at least two among a product substrate, a monitor substrate, a side dummy substrate, a supplementary dummy substrate and an adjustment dummy substrate.

8. The substrate processing apparatus of claim 1, wherein one of the first material and the second material is transparent and the other one of the first material and the second material is not translucent, and
the mapping apparatus is further configured to be capable of determining the material of the substrate accommodated in the carrier placed on a stage through which the carrier is transferred between an inside and an outside of the substrate processing apparatus.

9. The substrate processing apparatus of claim 1, wherein the mapping apparatus comprises:
a sensor configured to irradiate a reference light onto the substrate accommodated in the carrier and to detect a light transmitted through or reflected by the substrate;
a driver configured to enable the sensor to move relative to the substrate accommodated in the carrier along an arrangement direction of the substrate; and
a controller configured to be capable of holding master data for a plurality of combinations of a substrate size and a substrate material based on a light receiving pattern previously acquired from a substrate normally accommodated, and capable of checking an accommodation state of a substrate to be checked using the master data corresponding thereto.

10. The substrate processing apparatus of claim 9, wherein the sensor is a reflection type sensor configured to irradiate an end surface of the substrate with a laser light perpendicular to the end surface of the substrate and parallel to a main surface of the substrate, and further configured to receive the laser light reflected from the end surface.

11. The substrate processing apparatus of claim 10, further comprising
a transmission type sensor configured to irradiate a reference light onto the substrate accommodated in the carrier, and configured to detect a light transmitted through the substrate,
wherein the controller is further configured to be capable of determining a presence or absence and the material of the substrate from output results of both the transmission type sensor and the reflection type sensor.

12. The substrate processing apparatus of claim 1, wherein the controller is further configured to be capable of selecting master data for each job in response to a designation of a size and a material of each substrate in the carrier, and capable of checking an accommodation state of the substrate.

13. The substrate processing apparatus of claim 2, wherein the controller is further configured to be capable of determining a thickness of the substrate by detecting a light reception level of the reflection type sensor while moving the reflection type sensor along a substrate stacking direction of the carrier, and capable of determining the material of the substrate by referring to information associating the thickness of the substrate with the material of the substrate.

14. The substrate processing apparatus of claim 1, wherein the controller is further configured to be capable of distinguishing between a silicon carbide substrate and a silicon substrate accommodated in the carrier.

15. The substrate processing apparatus of claim 1 or 3, wherein the master data is configured to hold one or more sets of a substrate diameter, a carrier's reference slot height, a slot interval and number of slots, and further configured to hold a threshold value of a light reception level for each substrate material.

16. The substrate processing apparatus of claim 2, wherein the reflection type sensor is a limited reflection type sensor provided with a detection area that spreads flatly along a plane within a predetermined distance range, and is located such that a distance to the substrate accommodated in the carrier is within the predetermined distance range.

17. A mapping apparatus comprising:
(a) a sensor configured to irradiate a reference light onto a substrate accommodated in a carrier and to detect a light transmitted through or reflected by the substrate;
(b) a driver configured to enable the sensor to move relative to the substrate accommodated in the carrier along an arrangement direction of the substrate; and
(c) a controller configured to be capable of holding master data for a plurality of combinations of a substrate size and a substrate material based on a light receiving pattern previously acquired from a substrate normally accommodated, and capable of checking an accommodation state of a substrate to be checked using the master data corresponding thereto.

18. A substrate processing method comprising:
determining a material of a substrate using a mapping apparatus, wherein the substrate is accommodated in a carrier and loaded into a substrate processing apparatus;
updating first information on the material of the substrate loaded into the substrate processing apparatus; and
taking out the carrier accommodating the substrate when the first information on the material of the substrate does not satisfy a predetermined condition specified for each of a plurality of operation modes.

19. A method of manufacturing a semiconductor device comprising
the method of claim 16.

20. A non-transitory computer-readable recording medium storing a program that causes, by a computer, a substrate processing apparatus to perform:
determining a material of a substrate using a mapping apparatus, wherein the substrate is accommodated in a carrier and loaded into a substrate processing apparatus;
updating first information on the material of the substrate loaded into the substrate processing apparatus; and
taking out the carrier accommodating the substrate when the first information on the material of the substrate does not satisfy a predetermined condition specified for each of a plurality of operation modes.
